# EUROPEAN PATENT APPLICATION

(11) **EP 1 880 977 A2**
(43) Date of publication of application: **23.01.2008**
(21) Application number: 07112635.3
(22) Date of filing: 17.07.2007
(51) Int. Cl.: B81C 1/00

(54) **Silicon on metal for MEMS devices**

(30) Priority: 21.07.2006 US 459307
(71) Applicant: Honeywell International Inc., Morristown, NJ 07960 (US)
(72) Inventor: Klein, Jonathan L., Redmond, WA 98052 (US); Pilchowski, Jorg, Mercer Island, WA 98040 (US)
(74) Representative: Haley, Stephen

(57) **Abstract**

Micro-electromechanical systems (MEMS) pre-fabrication products and methods for forming MEMS devices using silicon-on-metal (SOM) wafers. An embodiment of a method may include the steps of bonding a patterned SOM wafer to a cover wafer (46), thinning the handle layer of the SOM wafer (48), selectively removing the exposed metal layer (50), and either continuing with final metallization (64) or cover bonding to the back of the active layer (62).

## Description

A method of producing microelectromechanical systems (MEMS) sensors and actuators which are built up by stacking single-crystalline layers of thicknesses less than the thickness of a standard silicon layer typically involves patterning, bonding, and thinning. The single-crystalline layer is supported by a sacrificial support wafer. The single-crystalline layer is patterned on the sacrificial wafer. The single-crystalline layer is then bonded to the device substrate wafer which is typically patterned with recesses, holes, and/or electrical traces. The sacrificial wafer is removed exposing the patterned single-crystalline patterned layer. More layers can be bonded and thinned using the same process as well as adding a cap wafer. This process may require an etch stop between the single-crystalline layer and the sacrificial wafer. The primary purpose of the etch stop may be to ease sacrificial wafer removal after bonding by providing a protection to the single-crystalline layer. The etch stop may also be used to ease patterning of the single-crystalline layer. Three methods used today are heavily doped epitaxial silicon layers, silicon-on-insulator (SOI), and thin wafer processing. Each of these processes have advantages and disadvantages in processing options (bonding and thinning), device geometry design rules, material constraints, and thermal limitations.

U.S. Patent No. 6,991,995 entitled "METHOD OF PRODUCING A SEMICONDUCTOR STRUCTURE HAVING AT LEAST ONE SUPPORT SUBSTRATE AND AN ULTRATHIN LAYER" issued to Aulnette et al. on January 31, 2006, and herein incorporated by reference, discloses one method of producing ultrathin layers.

New systems and methods are needed to address some of the above limitations, including the cost of using new sacrificial wafers each time the process is performed.

The present invention includes a device and method for producing Micro-Electromechanical Systems (MEMS) devices using silicon on metal (SOM) wafers. An embodiment of a method includes bonding a patterned SOM wafer to a cover wafer, thinning the handle (or sacrificial) layer of the SOM wafer, selectively removing the exposed metal layer, and either continuing with final metallization or cover bonding to the back of the active layer.

Further embodiments include creating an SOM wafer and patterning an SOM wafer. Patterning includes using the metal layer as a non-charging etch stop during plasma etching.

In accordance with other aspects of the invention, thinning the handle layer includes using the metal layer as an etch stop.

In accordance with still further aspects of the invention, the method includes the step of high temperature fusion bonding after the step of selectively removing the exposed metal layer.

In accordance with other aspects of the invention, a first metallic layer is precipitated onto the first surface of a first substrate wafer with substantially planar first and second opposed surfaces. A handle layer is bonded to the first metallic layer to form a bonding layer in opposed relation to the first surface. Mechanical structures (e.g. beams and trenches) are fabricated into the first substrate wafer. A second substrate layer is bonded to the second substrate surface to form a substrate assembly. The bonding layer is dissolved and the handle layer is removed from the substrate assembly.

Other aspects of the invention include using a perforated sacrificial wafer, which may be reused; using all metal or all polymer interlayers; and, bonding additional mechanism layers to the structure.

As will be readily appreciated from the foregoing summary, the invention provides a system and method for using SOM wafers in the fabrication of MEMS devices having single-crystalline layers.

**IN THE DRAWINGS:**
The preferred and alternative embodiments of the present invention are described in detail below with reference to the following drawings:

FIGURES 1-5 are side views of various intermediate structures produced by a method according to the present invention;

FIGURES 6A and 6B are side and bottom views of an alternate embodiment of the structure of FIGURE 1;

FIGURE 7 is a side view of another alternate embodiment of the structure of FIGURE 1;

FIGURE 8 is a side view of the structure of FIGURE 5 that includes components applied according to an alternate embodiment of the present invention;

FIGURE 9 is a block diagram of a method according to the present invention; and

FIGURE 10 is a block diagram of an alternate method according to the present invention.

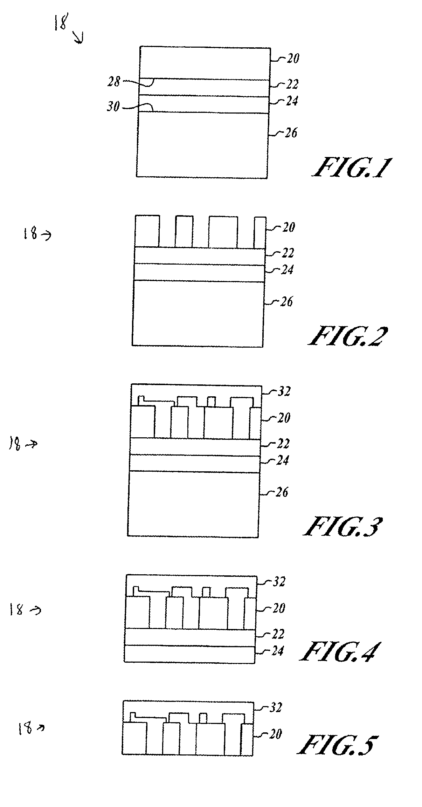

FIGURE 1 shows a side cross-sectional view of a structure 18 that includes a mechanism wafer 20, a metal layer 22, a metal or polymer layer 24, and a sacrificial (or handle) wafer 26. The mechanism wafer 20 and sacrificial wafer 26 may be standard single side polished silicon wafers. The metal layer 22 is produced by metallizing a bottom face 28 of the mechanism wafer 20, and the metal or polymer layer 24 is produced by metallizing or polymerizing a top face 30 of the sacrificial wafer 26. The faces 28, 30 with attached layers 22, 24 are bonded to each other using various bonding methods; bonding methods include low temperature thermal compression bonding for a metal to metal bond. The mechanism wafer 20 is thinned to a desired thickness using, for example, lapping and polishing.

FIGURE 2 shows the structure of FIGURE 1 after etching the mechanism wafer 20 to form various components of a MEMS device. The mechanism wafer 20 is masked and etched to the metal layer 22 (which may function as an etch stop), after which the mask is removed. Etching may include, for example, wet chemical etching selective to metal such as etching in tetramethyl-ammonium-hydroxide (TMAH) solution or in hydrazine solution. Etching may further include, for example, plasma etching using flourine or chlorine radicals. Plasma etching may include Deep Reactive Ion Etching (DRIE) to fabricate high aspect ratio structures in silicon. In the latter, the metal layer does not only function as an etch stop layer but also prevents lateral etching of the structure known as "footing" or "notching".

FIGURE 3 shows the structure of FIGURE 2 after bonding the mechanism wafer 20 to a patterned silicon device substrate wafer 32. Bonding methods include low temperature, temporary silicon-to-silicon fusion bonding the mechanism wafer 20 to the device substrate wafer 32.

FIGURE 4 shows the structure of FIGURE 3 after selective etching of the sacrificial wafer 26 to the metal or polymer layer 24. Etching may be accomplished by using wet chemical solutions such as TMAH or hydrazine, or by using plasma etching with flourine or chlorine radicals. The metal or polymer layer 24 acts as an etch stop. Etching may include a normal silicon etch technique which stops on metal (wet or dry), or alternatively underetching the entire wafer 26 through perforations with a selective metal wet etch.

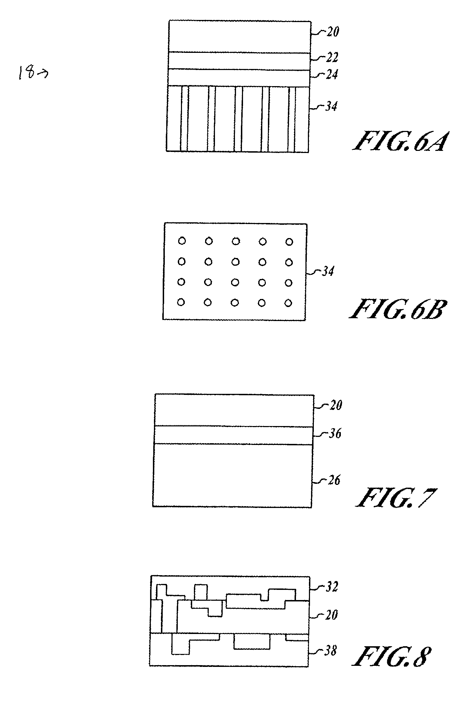

FIGURE 5 shows the structure of FIGURE 4 after removal of the metal and polymer layers 22, 24. Removal may be accomplished by metal etching in acidic solutions and by polymer etching using a solvent or in a plasma with oxygen radicals.

FIGURES 6A and 6B show side cross-sectional and top views, respectively, of an embodiment of a perforated sacrificial wafer 34 of the present invention. This embodiment may be substituted for the structure of FIGURE 1. The perforated wafer 34 may be perforated by etching holes and trenches using DRIE with flourine radicals. The perforated wafer 34 allows removal of the metal or polymer layer 24 without destruction of the wafer 34. The layer 24 is removed by introducing etchant into the perforations of the wafer 34. The etchant is chosen such that it will not etch the wafer 34, but will etch the layer 24. The wafer 34 is released upon removal of the layer 24, and may be reused.

FIGURE 7 shows an alternate embodiment of the structure of FIGURE 1. A layer 36 is either metal or polymer, and replaces the metal and metal or polymer layers 22, 24 of FIGURE 1.

FIGURE 8 shows the structure of FIGURE 5 after an optional additional layer 38 has been added to the structure 18. The layer 38 may be a capping wafer or an additional mechanism layer, or both, and may include silicon. Additional layers (not shown) may be attached.

FIGURE 9 is a block diagram of a method 40 according to the present invention. At a block 42, a silicon-on-metal (SOM) wafer with an active layer, a sacrificial layer, a metal layer, and a metal or polymer layer is formed. At a block 44, the active layer is patterned and etched to form MEMS components, and the internal metal layer may be used as an etch stop. At a block 46, the patterned SOM wafer is bonded to a cover wafer. At a block 48, the sacrificial layer of the SOM wafer is removed. Finally, at a block 50, the metal layer and metal or polymer layer are selectively removed.

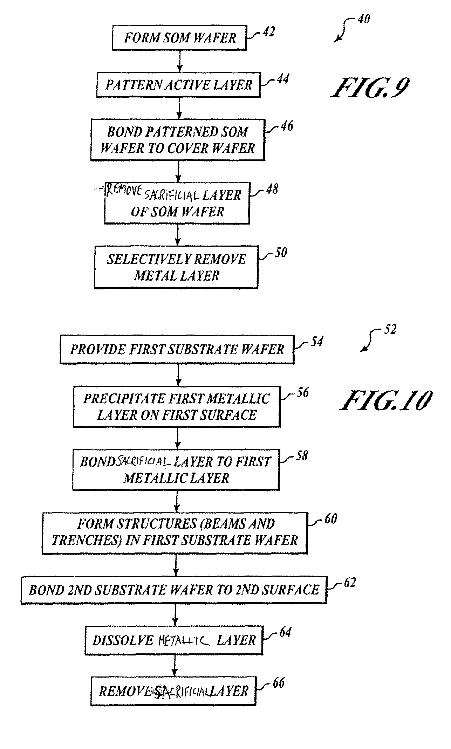

FIGURE 10 is a block diagram of an alternate method 52 according to the present invention. At a block 54, a first substrate wafer is provided. At a block 56, a first metallic layer is precipitated on a first surface of the substrate wafer. At a block 58, a sacrificial layer is bonded to the first metallic layer. At a block 60, structures such as beams and trenches are formed in the first substrate wafer. At a block 62, a second substrate wafer (which may be patterned) is bonded to a second surface of the first substrate wafer. At a block 64, the metallic layer is dissolved which releases the sacrificial layer.

While the preferred embodiment of the invention has been illustrated and described, as noted above, many changes can be made without departing from the spirit and scope of the invention. Accordingly, the scope of the invention is not limited by the disclosure of the preferred embodiment. Instead, the invention should be determined entirely by reference to the claims that follow.

## Claims

1. A method (40) comprising:
creating a silicon-on-metal (SOM) wafer including an active layer, a sacrificial layer, and an internal metallic layer (42); and
patterning and dry (plasma) or wet etching the active layer to form at least one micro-electromechanical system (MEMS) device component (44).

2. The method of Claim 1, wherein patterning and dry (plasma) etching include using the metal layer as a non-charging etch stop which prevents lateral etching of the structures (44).

3. The method (40) of Claim 1, further including:
bonding the patterned SOM wafer to a cover wafer (46);
thinning the sacrificial layer of SOM wafer (48); and
selectively removing the metal layer (50).

4. The method of Claim 3, wherein thinning (48) includes using the metal layer as an etch stop (44).

5. The method of Claim 3, further including:
performing a high temperature fusion bond of the patterned SOM wafer to the cover wafer (46).

6. The method of Claim 3, further including:
metallizing the etched mechanism wafer to form MEMS components (44).

7. A method for fabricating micro-electro-mechanical system (MEMS) devices, comprising:
providing a first substrate wafer having substantially planar parallel first and second substrate surfaces in opposed relation to each other (54);
precipitating a first metallic layer on the first surface (56);
bonding a sacrificial layer and the first metallic layer in opposed relationship to the first surface (58);
fabricating one or more micro-electromechanical systems (MEMS) device components in the first substrate wafer (60);
bonding a second substrate layer to the second substrate surface to form a substrate assembly (62);
dissolving the bond between the sacrificial layer and the first metallic layer (64); and
removing the sacrificial layer from the substrate assembly (66).

8. The method of Claim 7, wherein the fabricating includes (60):
charging the first metallic layer (60); and
etching the first substrate layer using radicals assisted by a directional ion flux (60).

9. The method of Claim 7, further including:
dissolving the first metallic layer to expose the first substrate surface (64); and
bonding a third substrate wafer to the first substrate surface to form an augmented substrate assembly (62).

10. An intermediate fabrication product in the production of MEMS devices, the intermediate fabrication product comprising:
a first substrate wafer having substantially planar parallel first and second substrate surfaces spaced apart in opposed relation to one another (20);
a first metallic layer bonded to the first substrate surface at a first metallic surface, and having a second metallic surface substantially parallel with the first metallic surface (22); and
a sacrificial substrate bonded to the second metallic surface (26).
